# EUROPÄISCHE PATENTSCHRIFT

(11) **EP 1 390 969 B1**
(45) Veröffentlichungstag und Bekanntmachung des Hinweises auf die Patenterteilung: **09.04.2008**
(21) Anmeldenummer: 02737791.0
(22) Anmeldetag: 13.04.2002
(51) Int. Cl.: H01L 21/00

(54) **VORRICHTUNG ZUR ERWÄRMUNG VON SUBSTRATEN MIT SEITENBLENDEN UND SEKUNDÄREN REFLEKTOREN**
DEVICE FOR HEATING SUBSTRATES WITH SIDE SCREENS AND SECONDARY REFLECTORS
DISPOSITIF POUR RECHAUFFER DES SUBSTRATS A L'AIDE D'ECRANS LATERAUX ET DE REFLECTEURS SECONDAIRES

(30) Priorität: 28.05.2001 DE 10126019; 08.10.2001 DE 20116416 U
(43) Veröffentlichungstag der Anmeldung: 25.02.2004
(73) Patentinhaber: Ackermann, Gunther, 81737 München (DE); Gerstendörfer-Hart, Barbara, 82544 Egling (DE)
(72) Erfinder: Ackermann, Gunther, 81737 München (DE); Gerstendörfer-Hart, Barbara, 82544 Egling (DE)
(86) Internationale Anmeldenummer: PCT/DE2002/001384
(87) Internationale Veröffentlichungsnummer: WO 2002/098175

(56) Entgegenhaltungen:
- DE-A- 19 923 400
- US-A- 4 832 777
- US-A- 5 892 886
- US-A- 6 080 965
- US-A- 6 108 491
- PATENT ABSTRACTS OF JAPAN vol. 1995, no. 07, 31. August 1995 (1995-08-31) -& JP 07 094415 A (FUJITSU LTD), 7. April 1995 (1995-04-07)

## Beschreibung

Die vorliegende Erfindung betrifft eine Temperierungsvorrichtung für Substrate, die mindestens einen Emitter für elektromagnetische Strahlung, insbesondere für kurzwellige Infrarotstrahlung, mindestens einen primären Reflektor sowie mindestens eine starre oder verstellbare Blende und mindestens einen sekundären Reflektor gemäß dem Patentanspruch 1 umfaßt.

Unter dem Begriff eines "zu erwärmenden Substrates (5)" sind im Rahmen der vorliegenden Erfindung grundsätzlich alle Gegenstände, Unterlagen, Grundmaterialien, Lackschichten, Klebstoffschichten, beidseitig adhäsive Klebstoffbänder, insbesondere mit einer thermisch aktivierbaren Klebstoffseite, Papierschichten, bedruckte Papier- oder Kunststoffbahnen, Kunststofffolien oder beschichtete oder unbeschichtete Gegenstände, insbesondere Platten, Profile oder Rohre, aus Metall, Kunststoff, einem Elastomer oder aus Glas zu verstehen, welche aus einem bestimmten Grunde beispielsweise zu Herstellungs-, Verarbeitungs- oder Anwendungszwecken punktförmig, abschnittsweise oder ganzflächig erwärmt oder erhitzt werden sollen.

Derartige Vorrichtungen zur Temperierung von Substraten werden dazu verwendet, verschiedenste Materialien zu erwärmen, um diese weiter verarbeiten zu können oder um einen oder mehrere Verarbeitungsschritte zu vollziehen.

Aus dem Stand der Technik sind diverse Systeme zur Temperierung von Substraten mit Hilfe kurzwelliger Infrarotstrahlung bekannt, bei denen eine Bündelung des Strahlengangs durch bestimmte Reflektorgeometrien oder Reflektorgestaltungen erfolgt:

In der EP 0521773 werden eine Vorrichtung sowie ein Verfahren offenbart, wobei im Bereich kurzwelliger IR-Strahlung Vorformlinge orthogonal zu ihrer Längsachse bestrahlt werden.

Eine flächenbezogen definierbare Immission am Substrat sowie eine minimierte Streustrahlung sind hier nicht erzielbar.

Aus der DE-OS 19850865 ist ferner eine Emitter- und Reflektorgestaltung bekannt, die eine gezielte Reflexion eines wesentlichen Teils der vom Emitter in Gegenrichtung zum Substrat abgestrahlten Energie erlaubt.
Eine Homogenität der Energieverteilung des Strahlenbündels am Punkt der Immission sowie eine definierte Bündelung der Strahlung läßt sich mit der in dieser Schrift vorgeschlagenen Lösung jedoch nicht erreichen.

Eine weitere Vorrichtung zur Temperierung von Substratmaterial ist aus der DE-OS 19724621 bekannt.
Ein Primärreflektor ist dort zweiteilig mit gegenüberliegenden Konkav-Reflektoren ausgeführt.

Diese Lösung erlaubt eine Verminderung der Streustrahlung und eine Verbesserung der Genauigkeit der Fokussierung des Strahlenbündels am Immissionspunkt, ist jedoch durch parasitäre Erwärmungseffekte nur für geringere Strahlungsenergien geeignet.
Außerdem weist die auf das dortige Substrat abgegebene Strahlung hinsichtlich ihrer Energieverteilung einen ausgeprägten Kurvenverlauf auf. Die Intensität der an das Substrat abgegebenen Strahlung nimmt dort also vom Rand der Bestrahlung zur Mitte der Bestrahlung hin deutlich zu; die Intensitätsverteilung ist dort folglich nicht gleichmäßig und homogen.

Aus der US-A-5 892 886 ist eine in eine Reaktionskammer integrierte Vorrichtung zur Erzeugung von Strahlungshitze bekannt, bei welcher ein Wafer in einer Vakuumkammer von mehreren horizontal nebeneinander angeordneten Lichtquellen zu Erwärmungszwecken großflächig und regelmäßig jedoch mit geringer Strahlungsenergie bestrahlt wird.

Die US-A-6 108 491 offenbart einen Reflektor für zwei auf unterschiedlichen Ebenen, hintereinander vorgesehene Heizlampen, welcher die von den beiden Heizlampen ausgehende Wärmestrahlung großflächig und ebenfalls lediglich mit geringer Strahlungsenergie auf einen Substratträger ausrichtet.

Aus der DE 199 23 400 A1 geht eine Reaktionskammer für die thermische und chemische Behandlung von Wafern hervor, bei welcher im Deckenbereich eine Vielzahl von Halogenlampen horizontal nebeneinanderliegend, zur Bestrahlung mit ebenfalls geringer Strahlungsenergie, vorgesehen ist.

Aus der US-A-6 080 965 geht eine Vorrichtung zur punktförmigen Erwärmung eines Halbleiter-Wafers hervor, welche eine Halogenlampe zur Emission von Licht im Brennpunkt eines halb-elliptischen Spiegels umfasst.
Das von der dortigen Halogenlampe abgegebene Licht wird zunächst an einem im Querschnitt halb-elliptischen Spiegel reflektiert und von dem halb-elliptischen Spiegel (46) punktförmig auf die Oberfläche des Wafers (W) fokussiert.

Aufgabe der vorliegenden Erfindung ist daher die Bereitstellung einer Vorrichtung zur Temperierung von Substraten, bei der die Strahlung das zu erwärmende Material mit einer definierten Mindest-Energiedichte bei weitgehend homogener und gleichmäßiger Energieverteilung bestrahlt, und bei der die Immission am Substrat auf einer definierbaren Breite erfolgt.

Erfindungsgemäß wird diese Aufgabe bei einer gattungsgemäßen Vorrichtung durch die im kennzeichnenden Teil des Patentanspruchs 1 angegebenen Merkmale gelöst.

Besonders bevorzugte Ausführungsformen sind Gegenstand der Unteransprüche.

Ausführungsbeispiele der Erfindung werden anhand der Zeichnungen näher beschrieben. Es zeigen:

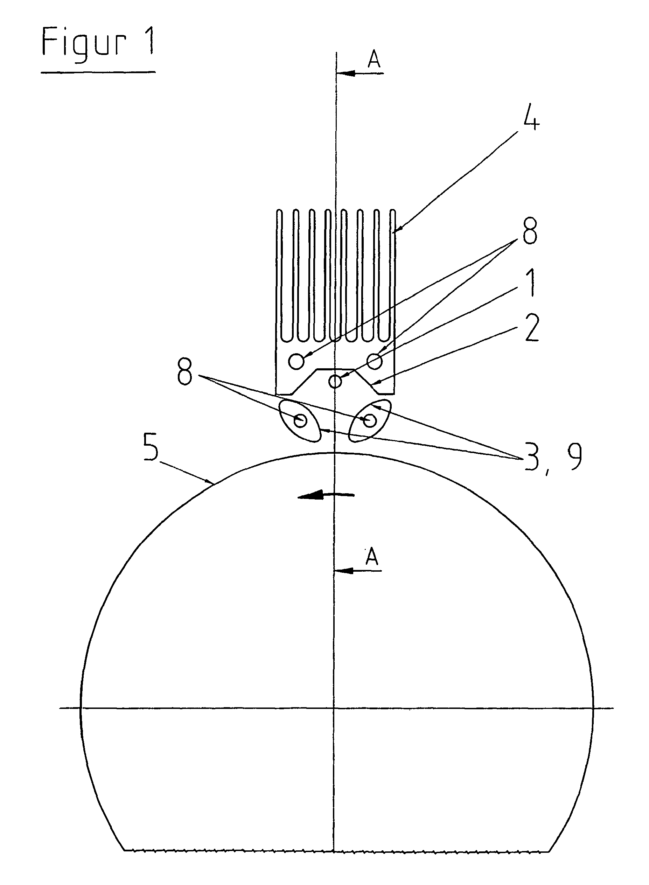

Figur 1 einen schematischen Querschnitt durch eine erfindungsgemäße Vorrichtung zur Erwärmung eines sich bewegenden Substrates (5) mit einem Emitter (1), mit einem als Polygonzug ausgeführten primären Reflektor (2) mit Kühlkörper (4) sowie mit zwei im Strahlengang befindlichen, drehbar gelagerten Blenden (3) oder sekundären Reflektoren (9), wobei innerhalb des primären Reflektors (2) und der Blenden (3) beziehungsweise innerhalb der sekundären Reflektoren (9) jeweils ein Kanal (8) zur Führung eines gasförmigen oder flüssigen Kühlmittels verläuft und wobei die Blenden (3) oder die sekundären Reflektoren (9) die Fläche des das Substrat (5) beaufschlagenden Strahlenbündels (6) begrenzen und wobei durch eine synchrone oder asynchrone Drehung der Blenden (3) oder der sekundären Reflektoren (9) die durch das Strahlenbündel auf dem Substrat (5) beaufschlagte Fläche in ihrer Größe und Form verändert werden kann;

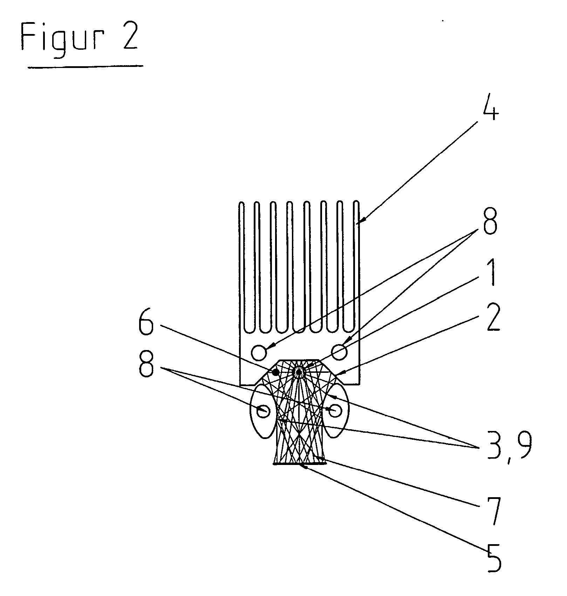

Figur 2 einen schematischen Querschnitt durch eine erfindungsgemäße Vorrichtung zur Erwärmung eines Substrates, wobei die Begrenzung der am Substrat (5) wirksamen Strahlung (7) durch fokussierend eingestellte Blenden (3) oder sekundäre Reflektoren (9) erfolgt und wobei durch die dargestellte Form und Ausrichtung des primären Reflektors (2) sowie der Blenden (3) oder der sekundären Reflektoren (9) Mehrfachreflexionen und ein homogenes Strahlenbündel (6) erzeugt werden.

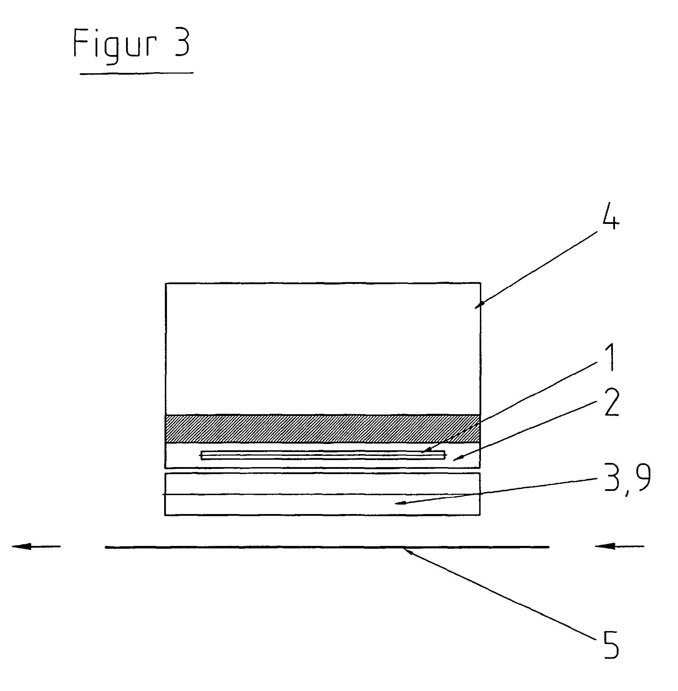

Figur 3 einen schematischen Querschnitt durch eine erfindungsgemäße Vorrichtung entlang der Linie A-A in Figur 1;

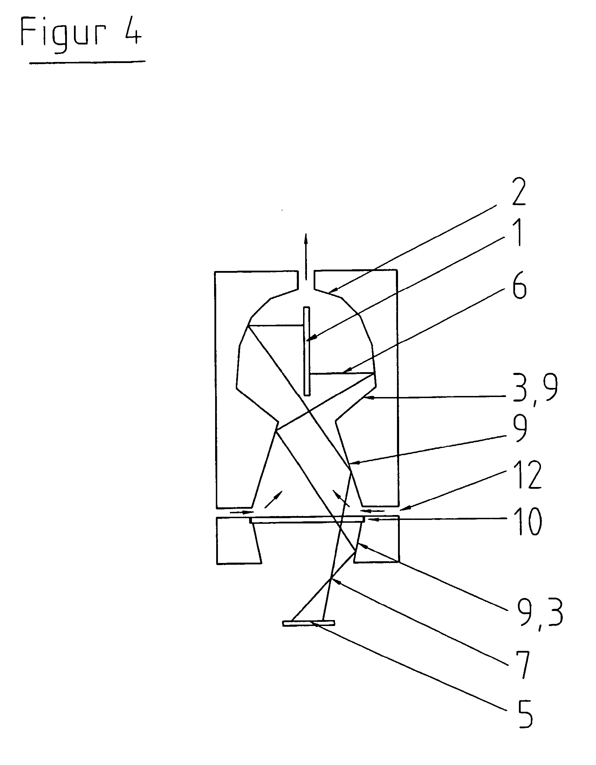

Figur 4 einen schematischen Querschnitt durch eine erfindungsgemäße Vorrichtung mit einem vertikal ausgerichteten Emitter (1), einem primären Reflektor (2), Blenden (3) und hierzu strahlungsabwärts nachgeschalteten sekundären Reflektoren (9), wobei die dem Strahlengang zugewandten, innenliegenden Wandungen der Blenden (3) und der sekundären Reflektoren (9) jeweils gerade ausgestaltet sind;

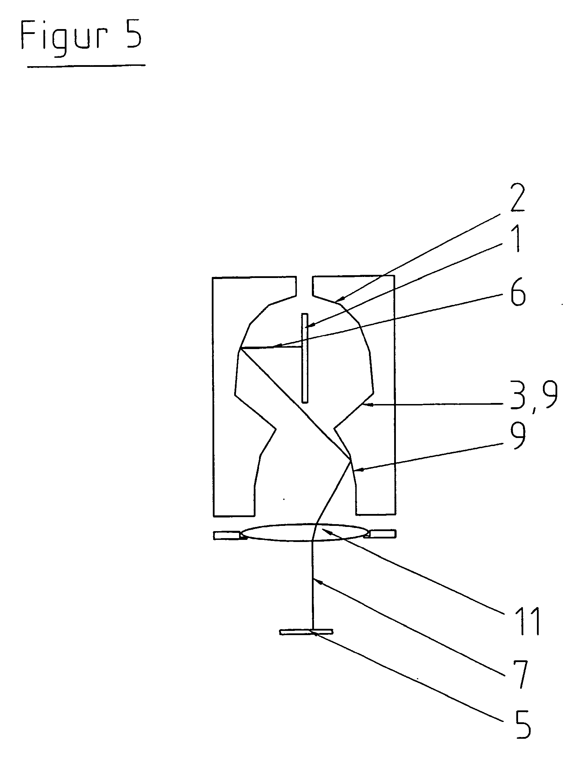

Figur 5 einen schematischen Querschnitt durch eine erfindungsgemäße Vorrichtung mit einem vertikal ausgerichteten Emitter (1), einem primären Reflektor (2), Blenden (3) und hierzu strahlungsabwärts nachgeschalteten sekundären Reflektoren (9), wobei die dem Strahlengang zugewandte innenliegende Wandung der Blenden (3) gerade ist, während die dem Strahlengang zugewandten Wandungen der sekundären Reflektoren (9) gekrümmt sind.

Wie bereits aus Figur 1 hervorgeht, umfaßt die erfindungsgemäße Vorrichtung zur Temperierung von Substraten in der Regel einen oder mehrere horizontal, schräg oder vertikal ausgerichtete Emitter (1) zur Emission elektromagnetischer Wellen (6) im Wellenlängenbereich von 200 nm bis 10000 nm.
Die Emitter (1) können starr oder hinsichtlich ihrer Position oder Ausrichtung veränderbar vorgesehen sein.

Vorzugsweise umfaßt die erfindungsgemäße Vorrichtung ferner einen oder mehrere primäre Reflektoren (2) insbesondere zur direkten und/oder indirekten Ausrichtung der von dem oder den Emittern (1) abgegebenen elektromagnetischen Strahlung (6) auf ein zu erwärmendes Substrat (5).

Im Falle einer indirekten Ausrichtung kann der Reflektor (2) die auf ihn auftreffende elektromagnetische Strahlung zunächst auf einen anderen Teil des Reflektors (2) und/oder auf einen anderen Reflektor (2) und/oder auf eine oder mehrere Blenden (3) oder sekundäre Reflektoren (9) einfach oder mehrfach abstrahlen.

Der primäre Reflektor (2) kann hinsichtlich seiner Querschnittsgeometrie oder hinsichtlich seiner Ausrichtung starr sein. Vorzugsweise ist der primäre Reflektor (2) jedoch hinsichtlich seiner Querschnittsgeometrie und/oder seiner Ausrichtung und/oder seines Anbringungsortes veränderbar.

In der Regel sind der oder die primären Reflektoren (2) im Querschnitt in Form eines Polygonzuges oder einer Kurve starr oder veränderbar ausgebildet.

Vorzugsweise sind in dem nachfolgenden Bereich zwischen dem Emitter (1) und dem zu bestrahlenden Substrat (5) oder einseitig oder beidseitig von diesem Bereich oder diesen Bereich vollständig oder abschnittsweise umlaufend ein oder mehrere feststehende oder hinsichtlich ihres Anbringungsortes und/oder ihrer Ausrichtung veränderbare Blenden (3) und/oder sekundäre Reflektoren (9) für die von dem oder den Emittern (1) und/oder von dem oder den primären Reflektoren (2) abgegebene oder reflektierte Strahlung (6) vorgesehen.

Diese Blenden (3) oder sekundären Reflektoren (9) können jeweils ein- oder mehrteilig ausgebildet sein.

In der Regel sind die Blenden (3) und/oder die sekundären Reflektoren (9) im Querschnitt in Form eines Polygonzuges oder einer Kurve starr oder veränderbar ausgebildet.

Vorzugsweise ist die von der erfindungsgemäßen Vorrichtung auf das Substrat (5) abgegebene Strahlung (6) hinsichtlich ihrer Energieverteilung weitgehendst homogen und gleichmäßig.

Im Allgemeinen dient die mindestens eine feststehende, verschiebbare oder schwenkbare Blende (3) zur Abschottung und damit zur Verringerung des Querschnittes des Strahlenganges (7).
Hierbei kann die mindestens eine Blende (3) die Breite des Strahlenbündels (6) gemäß permanenter oder variabler Grundeinstellung des Strahlengangs (7) begrenzen.

Alternativ oder zusätzlich hierzu kann die gegebenenfalls vorgesehene Blende (3) auch zur Ausrichtung der von dem Emitter (1) abgegebenen Strahlung dienen und zwar auf einen primären Reflektor (2) und/oder auf eine weitere Blende (3) und/oder auf einen sekundären Reflektor (9) und/oder auf ein Substrat (5), wobei in letztgenanntem Falle die Strahlung hinsichtlich ihrer Energieverteilung weitgehendst homogen und gleichmäßig ist.

Vorzugsweise richten der oder die sekundären Reflektoren (9) die von dem oder den Emittern (1) abgegebene oder von den primären Reflektoren (2) und/oder von den Blenden (3) reflektierte Strahlung punktförmig oder flächig oder streifenförmig und in einem hinsichtlich seiner Energieverteilung weitgehendst homogenen Strahl auf das Substrat (5) aus.

Die dem Strahlengang (7) zugewandte Wandung des sekundären Reflektors (9) und/oder der Blende (3) kann im Querschnitt beispielsweise linear, gerade oder konvex oder konkav gekrümmt oder in Form eines Polygonzuges ausgebildet sein.
In besonders bevorzugten Ausführungsformen weisen die in Richtung des oder der Emitter (1) und/oder in Richtung des oder der primären Reflektoren (2) weisenden Abschnitte der Blenden (3) und/oder der sekundären Reflektoren (9) eine glatte oder konvex oder konkav oder polygonal gewölbte Oberfläche auf, welche vorzugsweise zumindest abschnittsweise glänzend oder verspiegelt ist.

Eine derartige Ausgestaltung der Blenden (3) und/oder der sekundären Reflektoren (9) führt insbesondere zu dem Vorteil, daß die von dem oder den Emittern (1) und/oder von dem oder den primären Reflektoren (2) und/oder von der oder den Blenden (3) abgestrahlte Streustrahlung eingefangen werden kann.

Vorzugsweise wird die eingefangene Streustrahlung dann unmittelbar oder mittelbar über einen oder mehrere primäre Reflektoren (2) und/oder weitere Blenden (3) und/oder sekundäre Reflektoren (9) auf das zu erwärmende Substrat (5) in einem hinsichtlich der Energieverteilung weitgehend homogenen Strahl gebündelt.

Es erfolgt demnach eine Verstärkung der auf das zu erwärmende Substrat gestrahlten Strahlung durch Nutzung des von den Blenden (3) und/oder den sekundären Reflektoren (9) weggefangenen beziehungsweise reflektierten Streulichtes, wobei sich diese weggefangene Streustrahlung zu der von dem oder den Emittern (1) auf das Substrat (5) abgegebenen Strahlung addiert.

Wie insbesondere aus den Figuren 4 und 5 hervorgeht, können zwischen dem oder den Emittern (1) und dem zu erwärmenden Substrat (5) eine oder mehrere transparente Scheiben (10) und/oder Filterscheiben und/oder Linsen (11) vorgesehen werden.

Insbesondere Figur 4 zeigt, daß ein oder mehrere Luftkanäle (12) unterhalb und/oder oberhalb und/oder seitlich des oder der Emitter (1) zur Zuführung und/oder zur Abführung eines temperierten gasförmigen Mediums vorgesehen sein können, welches stromabwärts nach außen oder auf das Substrat (5) fließt.

Alternativ oder zusätzlich zu diesen Luftkanälen (12) können innerhalb der Wandungen des primären Reflektors (2) und /oder der Blende (3) und/oder des sekundären Reflektors (9) ein oder mehrere Kanäle (8) für ein flüssiges oder gasförmiges Kühlmittel verlaufen.

In einer bevorzugten Ausführungsform können zur Regelung der Durchlaßbreite des Strahlenganges (7) in Richtung des zu erwärmenden Substrates (5) zwei oder mehrere in Längsrichtung des Strahlengangs hintereinander angeordnete Blenden (3) und/oder sekundäre Reflektoren (9) vorgesehen werden.
In der Regel sind diese Blenden (3) und/oder sekundären Reflektoren (9) abhängig oder unabhängig voneinander hinsichtlich ihrer Position und/oder ihrer Ausrichtung veränderbar oder diesbezüglich unveränderbar ausgestaltet.
Vorzugsweise wird dort der Strahlendurchlaß beidseitig durch paarweise vorhandene Blenden (3) und/oder sekundäre Reflektoren (9) begrenzt.

Im Allgemeinen erfolgt die Veränderung der Position und/oder der Ausrichtung der beidseitig vorhandenen, paarweisen Blenden (3) und/oder sekundären Reflektoren (9) synchron oder asynchron für jeweils mindestens ein Paar gegenüberliegender Blenden (3) und/oder sekundärer Reflektoren (9).

Vorzugsweise können im Strahlengang ein oder mehrere Strahlenteiler vorgesehen sein.

Bei dem erfindungsgemäßen Verfahren zur Erwärmung von Substraten (5) wird in der Regel ein Substrat (5) von einem oder mehreren starren oder hinsichtlich ihrer Position und/oder ihrer Ausrichtung veränderbaren Emittern (1) zur Emission von elektromagnetischer Strahlung im Wellenlängenbereich von 200 nm bis 10000 nm bestrahlt.

Bei dieser Bestrahlung ist die Energieverteilung des Strahles vorzugsweise weitgehendst homogen und gleichmäßig.

Die Erwärmung des Substrates (5) kann bei dem erfindungsgemäßen Verfahren sowohl direkt durch die Strahlung des mindestens einen Emitters (1) als auch indirekt durch Einfach- oder Mehrfachreflexion der Strahlung an einem oder mehreren primären Reflektoren (2) und/oder an einer oder mehreren Blenden (3) und/oder an einem oder mehreren sekundären Reflektoren (9) erfolgen.

Im Allgemeinen sind der Emitter (1), die Reflektoren (2) und die Blenden (3) derart zueinander ausgerichtet oder ausrichtbar, daß die Abmessungen des das Substrat (5) bestrahlenden Strahlenbündels definiert beziehungsweise einstellbar sind.

In der Regel wird der Strahlengang (7) durch mindestens eine in ihrer Position oder Geometrie verstellbare Blende (3) und/oder einen sekundären Reflektor (9) dergestalt reguliert, daß die Bestrahlung des zu erwärmenden Substrates (5) auf einer exakt definierten Fläche erfolgt.

In der Regel liegt die frei wählbare oder fest einstellbare Breite des erzeugten, hinsichtlich der Energieverteilung weitgehend homogenen Strahles, im Bereich von 0,1 mm bis 150 mm, vorzugsweise im Bereich von 1 mm bis 100 mm, insbesondere im Bereich von 4 mm bis 60 mm.

Die frei wählbare oder fest einstellbare Länge des erzeugten, hinsichtlich der Energieverteilung weitgehendst homogenen Strahles, liegt beispielsweise im Bereich von 0,1 mm bis 10 m, vorzugsweise im Bereich von 10 mm bis 8 m, insbesondere im Bereich von 20 mm bis 6 m.

Alternativ oder zusätzlich hierzu ist es natürlich möglich, den von der erfindungsgemäßen Vorrichtung auf dem Substrat (5) abgebildeten Strahl in einem Auftreffpunkt auf dem Substrat (5) abzubilden.

In besonders bevorzugten Ausführungsformen sind die eine oder mehreren Blenden (3) und/oder sekundären Reflektoren (9) hinsichtlich ihrer Lage und/oder Ausrichtung derart verstellbar ausgestaltet, daß sie zumindest etwas in den Strahlengang (7) zwischen dem oder den Reflektoren (2) und dem zu erwärmenden Substrat (5) hineinragen.

So können die mindestens eine Blende (3) und/oder der mindestens eine sekundäre Reflektor (9) verschiebbar und/oder verschwenkbar sein, wobei durch die Verstellung der Blende (3) und/oder des sekundären Reflektors (9) der Querschnitt des Strahlenganges (7) variabel ist.

Vorzugsweise sind die Blenden (3) und/oder die sekundären Reflektoren (9) derart zumindest etwas innerhalb des oder der Strahlengänge (7) des oder der primären Reflektoren (2) starr oder hinsichtlich ihrer Positionierung und/oder Ausrichtung verstellbar vorgesehen, daß zumindest ein Teil der von dem oder den Emittern (1) abgegebenen Strahlung (6) auf ihrem Weg zu dem zu erwärmenden Substrat (5) Mehrfachreflexionen an der oder den Blenden (3) und/oder zwischen den Blenden (3) und/oder zwischen der oder den Blenden (3) und dem oder den primären Reflektoren (2) oder sekundären Reflektoren (9) erfährt.

Die Verstellung der mindestens einen Blende (3) oder des mindestens einen sekundären Reflektors (9) kann beispielsweise mechanisch und/oder elektrisch und/oder hydraulisch und/oder pneumatisch erfolgen.

In einer besonders bevorzugten Ausführungsform der erfindungsgemäßen Vorrichtung zur Erwärmung von Substraten können zur Regelung der Durchlaßbreite des Strahlenganges (7) in Längsrichtung des Strahlenganges (7) zwei oder mehrere Blenden (3) oder sekundäre Reflektoren (9) hintereinander angeordnet sein.

So können beispielsweise auf jeder Seite des Strahlenganges (7) mindestens zwei in Längsrichtung der Strahlen (6) nacheinander angeordnete Blenden (3) beziehungsweise Blendenpaare oder sekundäre Reflektoren (9) vorgesehen sein, so daß verschiedene Blendengeometrieen oder Reflektorgeometrieen während des Betriebs gewählt werden können.

Besonders einfach ist hiermit auch eine Blendengeometrie beziehungsweise Reflektorgeometrie darstellbar, die eine Mehrfachreflexion mindestens eines Teils des Strahlenbündels (6) erlaubt.

Vorzugsweise sind diese hintereinander angeordneten Blenden (3) oder sekundären Reflektoren (9) abhängig oder unabhängig voneinander verstellbar, wobei der Strahlendurchlaß vorzugsweise beidseitig durch paarweise vorhandene Blenden (3) oder sekundäre Reflektoren (9) begrenzt wird.

Gegebenenfalls ist zu beiden Seiten des Strahlenganges (7) mindestens je eine Blende (3) vorhanden, die synchron oder asynchron mit der jeweils gegenüberliegenden Blende (3) verstellbar ist. Gleiches gilt für die gegebenenfalls vorhandenen sekundären Reflektoren (9).

Im Allgemeinen sind die mindestens eine Blende (3) und/oder der mindestens eine sekundäre Reflektor (9) schwenkbar und/oder in Quer- beziehungsweise in Längsrichtung des Strahlenganges verschiebbar.

In einer weiteren bevorzugten Ausführungsform ist mindestens ein Paar gegenüberliegender Blenden (3) und/oder sekundärer Reflektoren (9) vorhanden, wobei bevorzugt eine synchrone Verstellung der jeweils gegenüberliegenden Blenden (3) oder sekundären Reflektoren (9) erfolgt.

In der Regel kann die Verstellung von paarweise vorhandenen Blenden (3) oder sekundären Reflektoren (9) synchron oder asynchron für jeweils mindestens ein Paar gegenüberliegender Blenden (3) oder sekundärer Reflektoren (9) erfolgen.

Alternativ oder zusätzlich hierzu können ein oder mehrere Blenden (3) und/oder sekundäre Reflektoren (9) eine variable Geometrie aufweisen.

In besonders bevorzugten Ausführungsformen der erfindungsgemäßen Vorrichtung zur Erwärmung von Substraten können jeder primäre Reflektor (2) und/oder jede Blende (3) und/oder jeder sekundäre Reflektor (9) über eine oder mehrere Kühlrippen (4) und/oder eine oder mehrere Aussparungen oder Kanäle (8) zur Durchleitung eines flüssigen oder gasförmigen Kühlmittels verfügen.

Vorzugsweise wird insbesondere der mindestens eine primäre Reflektor (2) mit einer Flüssigkeit oder einem Gas gekühlt. Alternativ oder zusätzlich hierzu kann der primäre Reflektor (2) beispielsweise rückwärtig und/oder seitlich einen Kühlkörper umfassen, welcher beispielsweise in Form von Kühlrippen (4) ausgestaltet ist.

In einer weiteren bevorzugten Ausführungsform ist der Emitter (1) druckdicht und/oder explosionsgeschützt ausgebildet.

Vorzugsweise sind einer oder mehrere der primären Reflektoren (2) oder der sekundären Reflektoren (9) als Polygonzüge ausgebildet und weisen somit jeweils einen polygonalen Querschnitt auf.

In einer besonders bevorzugten Ausführungsform der erfindungsgemäßen Vorrichtung zu Erwärmung von Substraten können der eine oder die mehreren Reflektoren (2; 9) eine verstellbare Geometrie aufweisen.

Alternativ oder zusätzlich hierzu können der eine oder die mehreren Reflektoren (2; 9) hinsichtlich ihrer Lage und/oder ihrer Ausrichtung verstellbar sein, wobei die Verstellung mechanisch und/oder elektrisch und/oder hydraulisch und/oder pneumatisch erfolgen kann.

Vorzugsweise können die Aufnahmepunkte der Emitter (1) in einzelnen oder mehreren Dimensionen verstellbar sein. Gegebenenfalls sind die Aufnahmepunkte des oder der Emitter (1) derart ausgestaltet, daß eine Neigung der Längsachse des Emitters (1) gegenüber der Ebene des Substrates (5) erzielbar ist.

Hierdurch kann zusätzlich zu einer gegebenenfalls vorhandenen Leistungsregelung des Emitters (1) eine Feinjustierung der Strahlungseinwirkung am Substrat (5) erfolgen.

In der Regel ist der mindestens eine Emitter (1) über eine oder mehrere Steckverbindungen fixiert und kann vorzugsweise an seinen Aufnahmepunkten hinsichtlich seiner Lage und/oder seiner Ausrichtung verstellt werden.

Beispielsweise ist der mindestens eine Emitter (1) in der Neigung und/oder in der Horizontalen und/oder in der Vertikalen und/oder parallel zu seiner Längsachse verstellbar ausgeführt.
In der Regel beträgt die Farbtemperatur des oder der Emitter (1) mindestens 2300° Kelvin.

Gegebenenfalls weist der mindestens eine Emitter (1) eine thermosensitive Abschaltung auf.
Alternativ hierzu kann jeder Emitter (1) mit einer automatischen Abschaltung in Verbindung stehen, welche beispielsweise über einen Temperatursensor oder einen Zeitschalter gesteuert wird.

Gegebenenfalls ist der besagte Temperaturfühler explosionsgeschützt angebracht.

In bevorzugten Ausführungsformen der erfindungsgemäßen Vorrichtung zur Erwärmung von Substraten können im Strahlengang (7) ein oder mehrere Strahlenteiler vorgesehen sein.

In bevorzugten Ausführungsformen kann die erfindungsgemäße Vorrichtung zur Erwärmung von Substraten einen oder mehrere beispielsweise auf das zu erwärmende Substrat (5) gerichtete Luftkanäle zur Zuführung von Frischluft und/oder temperierter Luft und/oder eines anderen gasförmigen temperierten Mediums umfassen, um das zu erwärmende Substrat (5) hiermit zu temperieren und/oder um eine Trocknung des Substrates (5) zu unterstützen.

Alternativ oder zusätzlich zu der beispielsweise auf das Substrat (5) gerichteten Luftzuführung kann die erfindungsgemäße Vorrichtung einen oder mehrere Luftkanäle zur Abführung der zuvor zugeführten Frischluft, temperierten Luft oder eines gasförmigen, temperierten Mediums und/oder zur Abführung eines die erfindungsgemäße Vorrichtung durchströmenden gasförmigen Kühlmittels umfassen.

Vorzugsweise sind das Volumen und/oder die Strömungsgeschwindigkeit und/oder die Temperatur des durch den oder die Luftkanäle zu- oder abgeführten Stromes an gasförmigem Medium regelbar oder steuerbar.

In den Luftkanal kann beispielsweise über eine Düse mit starrem oder regulierbarem Querschnitt Frischluft oder temperierte Frischluft und/oder durch den Prozeß temperierte Luft einströmen.

In einer weiteren vorteilhaften Ausführungsform der erfindungsgemäßen Vorrichtung zur Erwärmung von Substraten sind ein oder mehrere Lösemittel-Abscheider und/oder ein oder mehrere Partikel-Abscheider in die Führung des gasförmigen Mediums integriert.

In besonders bevorzugten Ausführungsformen der erfindungsgemäßen Vorrichtung ist die Vorrichtung zur Erwärmung von Substraten (5) gegenüber dem zu erwärmenden Substrat (5) hinsichtlich ihrer Position und/oder ihrer Ausrichtung veränderbar vorgesehen.

Alternativ oder zusätzlich hierzu kann das zu erwärmende Substrat (5) gegenüber der Vorrichtung zur Erwärmung von Substraten (5) hinsichtlich seiner Position und/oder Ausrichtung veränderbar sein.

Ebenfalls in einer besonders bevorzugten Ausführungsform der erfindungsgemäßen Vorrichtung zur Erwärmung von Substraten (5) sind der oder die Emitter (1) derart gesteuert oder geregelt, daß sie nicht kontinuierlich, sondern in Abhängigkeit von dem Erreichen einer zur Bestrahlung geeigneten Position des Substrates (5) und/oder der Vorrichtung zur Erwärmung von Substraten (5), getaktet elektromagnetische Wellen emittieren.

Für sämtliche Ausführungsformen der erfindungsgemäßen Vorrichtung gilt, daß sowohl die bestrichene Fläche (7) als auch die Homogenität des Strahlenbündels weitgehend determinierbar sind, indem die Blenden- und/oder Reflektorgeometrie beziehungsweise die Blenden- und/oder Reflektorposition verändert werden.

## Patentansprüche

1. Vorrichtung zur Erwärmung von Substraten (5), welche einen oder mehrere starre oder hinsichtlich ihrer Position und/oder ihrer Ausrichtung veränderbare Emitter (1) zur Emission elektromagnetischer Strahlung (6) im Wellenlängenbereich von 200 nm bis 10000 nm sowie einen oder mehrere starre oder zumindest in ihrer Querschnittsgeometrie oder hinsichtlich ihrer Ausrichtung oder ihres Anbringungsortes veränderbare primäre Reflektoren (2) zur direkten und/oder indirekten Ausrichtung der von dem oder den Emittern (1) emittierten elektromagnetischen Strahlung (6) in Richtung eines zu bestrahlenden Substrates (5) umfaßt, wobei der oder die primären Reflektoren (2) im Querschnitt in Form eines Polygonzuges oder einer Kurve starr oder veränderbar ausgebildet sind und wobei in dem nachfolgenden Bereich zwischen dem Emitter (1) und dem zu bestrahlenden Substrat (5) oder einseitig oder beidseitig von diesem Bereich oder diesen Bereich vollständig oder abschnittsweise umlaufend ein oder mehrere feststehende oder hinsichtlich ihres Anbringungsortes und/oder ihrer Ausrichtung veränderbare Blenden (3) und sekundäre Reflektoren (9) für die von dem oder den Emittern (1) und/oder dem oder den primären Reflektoren (2) abgegebene oder reflektierte Strahlung (6, 7) vorgesehen sind, welche jeweils ein- oder mehrteilig ausgestaltet sind und im Querschnitt in Form eines Polygonzuges oder einer Kurve starr oder veränderbar ausgebildet sind, wobei der oder die sekundären Reflektoren (9) die von dem oder den Emittern (1) abgegebene oder von den primären Reflektoren (2) und/oder von den Blenden (3) reflektierte Strahlung (6, 7) punktförmig oder streifenförmig auf das Substrat (5) ausrichten, **dadurch gekennzeichnet, dass** die feststehende, verschiebbare oder schwenkbare Blende (3) zur Abschottung und damit zur Verringerung des Querschnittes des Strahlenganges (7).

2. Vorrichtung nach Anspruch 1, **dadurch gekennzeichnet, dass** die dem Strahlengang (7) zugewandte Wandung des sekundären Reflektors (9) und/oder der Blende (3) im Querschnitt linear, gerade oder konvex oder konkav gekrümmt ist oder in Form eines Polygonzuges ausgebildet und ganzflächig oder abschnitttsweise glänzend oder verspiegelt ist.

3. Vorrichtung nach einem der vorhergehenden Ansprüche, **dadurch gekennzeichnet, dass** zwischen dem oder den Emittern (1) und dem zu erwärmenden Substrat (5) eine oder mehrere transparente Scheiben (10) und/oder Filterscheiben und/oder Linsen (11) vorgesehen sind.

4. Vorrichtung nach einem der vorhergehenden Ansprüche, **dadurch gekennzeichnet, dass** ein oder mehrere Luftkanäle (12) unterhalb und/oder oberhalb und/oder seitlich des oder der Emitter (1) zur Zuführung und/oder zur Abführung eines temperierten gasförmigen Mediums vorgesehen sind, welches stromabwärts nach außen oder auf das Substrat (5) fließt.

5. Vorrichtung nach einem der vorhergehenden Ansprüche, **dadurch gekennzeichnet, dass** innerhalb der Wandungen des primären Reflektors (2) und /oder der Blende (3) und/oder des sekundären Reflektors (9) ein oder mehrere Kanäle (8) für ein flüssiges oder gasförmiges Kühlmittel verlaufen.

6. Vorrichtung nach einem der vorhergehenden Ansprüche, **dadurch gekennzeichnet, dass** zur Regelung der Durchlaßbreite des Strahlenganges (7) in Richtung des zu erwärmenden Substrates (5) zwei oder mehrere in Längsrichtung des Strahlengangs hintereinander angeordnete Blenden (3) und/oder sekundäre Reflektoren (9) vorgesehen sind, wobei diese Blenden (3) und/oder sekundären Reflektoren (9) abhängig oder unabhängig voneinander hinsichtlich ihrer Position und/oder ihrer Ausrichtung veränderbar oder diesbezüglich unveränderbar ausgestaltet sind, wobei der Strahlendurchlaß beidseitig durch paarweise vorhandene Blenden (3) und/oder sekundäre Reflektoren (9) begrenzt ist.

7. Vorrichtung nach einem der vorhergehenden Ansprüche, **dadurch gekennzeichnet, dass** die Veränderung der Position und/oder der Ausrichtung der beidseitig vorhandenen, paarweisen Blenden (3) und/oder sekundären Reflektoren (9) synchron oder asynchron für jeweils mindestens ein Paar gegenüberliegender Blenden (3) und/oder sekundärer Reflektoren (9) erfolgt.

8. Vorrichtung nach einem oder mehreren der vorhergehenden Ansprüche, **dadurch gekennzeichnet, daß** im Strahlengang ein oder mehrere Strahlenteiler vorgesehen sind.

## Claims

1. A device for heating substrates (5) comprising one or several emitter/s (1), which is/are rigid or changeable with regard to position and/or orientation, for emitting electromagnetic radiation (6) in the wavelength range of 200 nm to 10,000 nm plus one or several primary reactor/s (2), which is/are rigid or changeable at least in their cross-sectional geometry or with regard to their orientation or attachment position, for reflecting, directly and/or indirectly in the direction of a substrate (5) to be irradiated, the electromagnetic radiation (6) emitted by the emitter/s (1), whereby the primary reflector/s (2) may have rigid or variable cross-sectional designs in the form of polygonal courses or of curves, and whereby the subsequent zone between the emitter (1) and the substrate (5) to be irradiated, or a region to one or both sides of this zone, or a region fully or partially surrounding this zone, contains, for the radiation (6, 7) emitted by the emitter/s (1) and/or reflected by the primary reflector/s (2), one or several shutters (3) and secondary reflectors (9), which are rigid or changeable with regard to their attachment position and/or their orientation and which may each be designed in one or several parts and which have rigid or variable cross-sectional designs in the form of polygonal courses or of curves, and whereby the secondary reflector/s (9) reflect, punctiform or in lamellar form, onto the substrate (5), the radiation (6, 7) emitted by the emitter/s (1) and/or reflected by the primary reflectors (2) and/or the shutters (3), **characterized in that** the shutter (3), which may be rigid, sliding or swivelling, has the purpose of restricting and thereby reducing the cross-section of the path of rays (7).

2. A device according to claim 1, **characterized in that** the surrounding wall facing the path of rays (7) of the secondary reflector (9) and/or of the shutter (3) features a cross-section that is linear, straight or curved in a convex or concave form, or is designed in the form of a polygonal course and is completely or partially shiny or metallized.

3. A device according to one of the preceding claims, **characterized in that** one or several transparent discs (10) or filter discs and/or lenses (11) are provided between the emitter/s (1) and the substrate (5) to be heated.

4. A device according to one of the preceding claims, **characterized in that** one or several air ducts (12) are provided below and/or above and/or to the side of the emitter/s (1) for the supply and/or discharge of a temperate gaseous medium that flows downstream to the outside or onto the substrate (5).

5. A device according to one of the preceding claims, **characterized in that** one or several channels (8) for a liquid or gaseous cooling agent run inside the walls of the primary reflector (2) and/or the shutter (3) and/or the secondary reflector (9).

6. A device according to one of the preceding claims, **characterized in that**, for controlling the width of passage of the path of rays (7) in direction of the substrate (5) to be heated, two or several shutters (3) and/or secondary reflectors (9), arranged in sequence in longitudinal direction of the path of rays, are provided, whereby the said shutters (3) and/or secondary reflectors (9) with regard to their positions and/or their orientation may be variable independently or in combination with one another or may be unchangeable in this respect and whereby the said passage of the rays is limited on either side by shutters (3) and/or secondary reflectors (9) existing in pairs.

7. A device according to one of the preceding claims, **characterized in that** the adjustment of the position and/or orientation of the pairs of shutters (3) and/or secondary reflectors (9) existing on both sides is done synchronously or asynchronously for at least one pair of opposite shutters (3) and/or secondary reflectors (9).

8. A device according to one of the preceding claims, **characterized in that** one or several beam dividers are provided in the path of the rays.

## Revendications

1. Dispositif pour l'échauffement de substrats (5), comprenant un ou plusieurs émetteurs (1) fixes ou modifiables quant à leur position et/ou leur orientation, pour l'émission d'un rayonnement électromagnétique (6) dans la gamme de longueurs d'ondes de 200 nm à 10000nm, ainsi qu'un ou plusieurs réflecteurs primaires (2) fixes ou modifiables au moins quant à la géométrie de leur coupe transversale ou quant à leur orientation ou leur lieu d'installation, pour l'orientation directe et/ou indirecte du rayonnement électromagnétique (6) émis par le ou les émetteurs (1), dans la direction d'un substrat (5) à irradier, le ou les réflecteurs primaires (2) étant conçus en forme de cheminement polygonal ou de courbe fixe ou modifiable dans leur coupe transversale, un ou plusieurs panneaux (3) et réflecteurs secondaires (9), immobiles ou modifiables quant à leur emplacement et/ou leur orientation, étant prévus dans la zone suivante, entre l'émetteur (1) et le substrat (5) à irradier, ou bien d'un côté ou des deux côtés de cette zone, ou encore tout autour ou par tronçons autour de cette zone, pour le rayonnement (6, 7) réfléchi ou émis par le ou les émetteurs (1) et/ou le ou les réflecteurs primaires (2), qui sont constitués chacun d'une ou de plusieurs pièces et conçus en forme de cheminement polygonal ou de courbe fixe ou modifiable dans leur coupe transversale, le ou les réflecteurs secondaires (9) orientant, sous forme de points ou de bandes, le rayonnement (6, 7) émis par le ou les émetteurs (1) ou réfléchi par les réflecteurs primaires (2) et/ou par les panneaux (3), vers le substrat (5), **caractérisé en ce que** le panneau (3) immobile, déplaçable ou pivotant sert au cloisonnage et donc à réduire la coupe transversale de la trajectoire des rayons (7).

2. Dispositif selon la revendication 1, **caractérisé en ce que** la paroi du réflecteur secondaire (9) et/ou du panneau (3) qui est tournée vers la trajectoire des rayons (7) est linéaire, droite ou courbée de manière convexe ou concave dans sa coupe transversale, ou conçue en forme de cheminement de polygone, et brillante ou réfléchissante, en partie ou sur toute la surface.

3. Dispositif selon l'une des revendications précédentes, **caractérisé en ce qu'**un ou plusieurs disques transparents (10) et/ou filtres lamineurs et/ou lentilles (11) sont prévus entre le ou les émetteurs (1) et le substrat (5) à échauffer.

4. Dispositif selon l'une des revendications précédentes, **caractérisé en ce que** un ou plusieurs canaux d'air (12) sont prévus en-dessous et/ou au-dessus et/ou sur le côté du ou des émetteurs (1), pour l'alimentation et/ou l'évacuation d'un produit sous forme de gaz tempéré, qui s'écoule en aval vers l'extérieur ou sur le substrat (5).

5. Dispositif selon l'une des revendications précédentes, **caractérisé en ce qu'**un ou plusieurs canaux (8) destinés à un liquide de refroidissement liquide ou gazeux passent à l'intérieur de la paroi du réflecteur primaire (2) et/ou du panneau (3) et/ou du réflecteur secondaire (9).

6. Dispositif selon l'une des revendications précédentes, **caractérisé en ce que** deux ou plusieurs panneaux (3) et/ou réflecteurs secondaires (9), disposés les uns à la suite des autres dans la direction longitudinale de la trajectoire des rayons, sont prévus pour l'ajustement de la largeur de passage de la trajectoire des rayons (7) dans la direction du substrat (5) à échauffer, ces panneaux (3) et/ou réflecteurs secondaires (9) étant conçus de façon modifiable ou non modifiable quant à leur position et/ou leur orientation, les uns par rapport aux autres ou indépendamment les uns des autres, le passage des rayons étant limité des deux côtés par des panneaux (3) et/ou des réflecteurs secondaires (9) disponibles par paires.

7. Dispositif selon l'une des revendications précédentes, **caractérisé en ce que** la modification de la position et/ou de l'orientation des paires de panneaux (3) et/ou de réflecteurs secondaires (9) disponibles des deux côtés est effectuée de manière synchrone ou asynchrone pour à chaque fois au moins une paire de panneaux (3) et/ou de réflecteurs secondaires (9) opposés.

8. Dispositif selon l'une ou plusieurs des revendications précédentes, **caractérisé en ce qu'**un ou plusieurs diviseurs de rayons sont prévus dans le passage des rayons.
